# EUROPEAN PATENT APPLICATION

(11) **EP 0 717 125 A1**
(43) Date of publication of application: **19.06.1996**
(21) Application number: 95308622.0
(22) Date of filing: 30.11.1995
(51) Int. Cl.: C23C 14/18, C23C 14/58, H01L 23/373

(54) **Bonding of diamond to a substrate**

(30) Priority: 15.12.1994 US 356090
(71) Applicant: GENERAL ELECTRIC COMPANY, Schenectady, NY 12345 (US)
(72) Inventor: Iacovangelo, Charles D., Schenectady, New York 12309 (US)
(74) Representative: Pratt, Richard Wilson

(57) **Abstract**

A method of metallization of diamond prepares it for thermocompression bonding to a substrate. A heat spreader comprises a metallized diamond element with a transition metal bonding layer and a precious metal layer, such as Ag or Au, and a base element with a transition metal bonding layer and a precious metal layer, such as Ag or Au. A method produces such a heat spreader by thermocompression bonding of a diamond element to a base element.

## Description

### Background of the Invention

This invention relates to a method for the metallization of diamond that allows the metallized diamond to be subsequently thermocompression bonded to a substrate. This bonded component can be used to spread heat away from high power devices in electronic applications. It can be used in a variety of single chip and multi-chip modules to provide maximum heat removal.

A limiting factor in many electronic applications is the ability to remove heat from high power devices so that the operating temperature will stay within an allowable range. Diamond is an excellent material for heat spreading under these power devices because of its high thermal conductivity and high electrical resistivity. Diamond is also expensive; therefore, it is preferable to keep the size of the diamond to a minimum. This can be accomplished by locating the diamond only under the active device with the diamond mounted onto a secondary substrate such as Al₂O₃ (alumina), AIN, SiC or CuW.

The method of mounting the diamond to the substrate is very important. Anything placed between the diamond and the substrate is in the thermal path. Methods such as soldering or brazing could be used but they generally result in devices that are poor thermal conductors. These methods also require tailoring the solder melting points so that a hierarchy of melting points for chip attach, lid sealing, lead attach, and soldering to a board can be achieved.

A much more efficient method would be to attach a thin layer of Au to the diamond. To bond Au to diamond, a transition metal bond layer would first be applied to the diamond. The Au layer would be deposited on and adhere to the transition metal bond layer. The gold coated diamond would then be thermocompression bonded to a thin layer of Au on the substrate. This method would provide a good thermal conductor and would not interfere with the solder hierarchy used within the complete package.

Thermocompression of Au to Au is well known in the art. It is widely used to make mechanical and electrical connections to thin film circuits or chips. For example, it is used in tape automated bonding where Au plated copper foil lead frames, which are patterned and supported on polymeric tape, are bonded to electroplated Au bump structures on the device bond pads. The bond is formed by applying pressure to the leads and the bumps with a heated thermode. This process produces a diffusion type bond between the Au plated lead and the Au bump. To achieve a good bond requires sufficient heat and pressure for some minimum period of time.

Two problems are encountered when attempting to bond diamond to a substrate in the manner described above: heat loss due to the thermal conductivity of both the diamond and the substrate, and migration of the transition metal bond layer into the Au. Both diamond and substrates such as AIN are very good conductors of heat. The temperatures normally used to bond Au to Au are insufficient to achieve a good bond because the heat is drawn away so quickly. To overcome this heat loss requires higher temperatures. However, at these elevated temperatures, the transition metals, such as Ti, that are used to bond the Au to the diamond can diffuse into the Au. This results in a poor bond between the Au on the diamond and the Au on the substrate. To overcome these difficulties, a metallization is required which can withstand the high temperatures of the bonding process and yet remain ductile and bondable. The present invention seeks to provide a metallization with these properties.

### Summary of the Invention

According to the present invention, there is provided a method for metallization of a diamond substrate, said method comprising the following steps:
a. coating of a diamond substrate with a substrate transition metal layer, and,
b. overcoating of said substrate transition metal layer with at least one substrate precious metal layer selected from the group consisting of Ag and Au, and,
c. heat treating of the coated diamond substrate at a temperature and for a time sufficient to bond the substrate transition metal layer and the substrate precious metal layer to said diamond.

According to another aspect of the present invention, there is provided a heat spreader, said heat spreader comprising the following elements:
a. a diamond element comprising
   i. a diamond substrate, and,
   ii. a substrate transition metal layer deposited onto and adhered to said diamond substrate, and,
   iii. at least one substrate precious metal layer deposited onto and adhered to said substrate transition metal layer selected from the group consisting of Ag and Au, and,
b. a base element comprising
   i. a base, and,
   ii. a base transition metal layer deposited onto and adhered to said base, and,
   iii. a base precious metal layer deposited onto and adhered to said base transition metal layer,
   wherein the precious metal layer of said diamond element is thermocompression bonded to the precious metal layer of said base element.

According to another aspect of the present invention, there is provided a method to produce a heat spreader comprising the following steps:
a. preparing a diamond element by
   i. depositing a substrate transition metal layer onto a diamond substrate, and,
   ii. depositing at least one substrate precious metal layer onto said substrate transition metal layer selected from the group consisting of Ag and Au, and,
   iii. heat treating the coated diamond substrate at a temperature and for a time sufficient to bond the substrate transition metal layer and the precious metal layer to said diamond substrate, and,
b. preparing a base element by
   i. depositing a base transition metal layer onto a base, and,
   ii. depositing a base precious metal layer onto the base transition metal layer, and,
c. thermocompression bonding the precious metal layer of the diamond element to the precious metal layer of the base element.

### Description of the Preferred Embodiments

An illustrative embodiment of the present invention includes a diamond substrate, a substrate transition metal layer bonded to said diamond substrate, a substrate precious metal layer bonded to said substrate transition metal layer, a base, a base transition metal layer bonded to said base, and a base precious metal layer bonded to said base transition metal layer. The coated diamond element and the coated base element are then thermocompression bonded together to form a heat spreader.

The diamond substrate comprises such materials as natural diamond and chemically vapor deposited diamond (CVDD), which can be produced by methods well known in the art.

The substrate transition metal layer may include Ti, Nb, W, Cr, Mo and alloys thereof. If W and Ti are used, preferably they are deposited as an alloy, but it is contemplated that the deposition may include thin layers. The W and Ti substrate transition metal layer preferably consists entirely of W and Ti metal. The W and Ti of the alloy can be prealloyed, or the alloy can be formed during the deposition process.

When Ti is a component of the substrate transition metal layer alloy, it should be present in an amount sufficient to provide a good bond to the diamond substrate. The W component of the alloy controls and reduces the activity of the Ti. Preferably the W and Ti metal layer comprises from 1 to 50% by weight Ti with the balance being W, more preferably from 10 to 30% by weight Ti with the balance being W. A substrate transition metal layer of a W-Ti alloy is preferably 500 to 10,000 Å thick.

The substrate precious metal layer comprises Ag or Au. Preferably, a first substrate precious metal layer comprising Ag is followed by a second substrate precious metal layer comprising Au. Preferred thickness of a substrate precious metal layer of Ag is 1000 to 20,000 Å, while the preferred thickness for a substrate precious metal layer of Au is 10,000 to 40,000 Å.

Both the substrate transition metal layer and the substrate precious metal layer(s) may be deposited by methods known in the art. These include evaporation, sputtering and chemical vapor deposition.

When only one substrate precious metal layer is applied, the heat treating is performed after deposition of the Au layer. Preferably, Ag is applied as a first substrate precious metal layer and, in that case, the heat treat operation is performed after deposition of the Ag and before deposition of the Au. This prevents migration of the Ag into the Au that can occur during heat treating.

Heat treating is performed at temperatures of 680° to 960°C for 5 to 60 minutes. The preferred atmosphere comprises a hydrogen/argon atmosphere of 4 to 100% by volume of hydrogen with the balance argon.

Base substrate materials include Al₂O₃ (alumina), AIN, SiC and CuW. The preferred base is AIN.

Preferably, the base transition metal layer comprises W and Ti. It can comprise any transition metal. As with the substrate transition metal layer, if W and Ti are used, preferably they are deposited as an alloy, but it is contemplated that the deposition may include thin layers. The W and Ti base transition metal layer preferably consists entirely of W and Ti metal. The W and Ti of the alloy can be prealloyed, or the alloy can be formed during the deposition process.

When Ti is a component of the base transition metal layer alloy, it should be present in an amount sufficient to provide a good bond to the base substrate. The W component of the alloy controls and reduces the activity of the Ti. Preferably the W and Ti metal layer comprises from 1 to 50% by weight Ti with the balance being W, more preferably from 10 to 30% by weight Ti with the balance being W. A base transition metal layer of a W-Ti alloy is preferably 500 to 10,000 Å thick.

The base precious metal layer comprises Ag or Au. It preferably comprises Au. The preferred thickness for a Au base precious metal layer is 10,000 to 40,000 Å. If Ag is the base precious metal layer, the preferred thickness is 1000 to 20,000 Å

Methods known in the art may be used to deposit the base transition metal layer and the base precious metal layer. These methods include evaporation, sputtering and chemical vapor deposition.

Thermocompression bonding of the diamond element to the base element is performed at pressures of 1400 to 2800 kg/cm². The temperature for bonding is 200° to 700°C. Preferably, the temperature during bonding is 550° to 700°C.

Following are examples presented to enable those skilled in the art to more clearly understand and to practice the present invention. Example 1 is provided to indicate the difficulties inherent in thermocompression bonding diamond substrates to bases.

### Example 1 (Control)

A series of AIN substrates (2 X 6 X 0.6 mm) was thermocompression bonded to CVDD substrates (1 X 0.6 X 0.26 mm). The CVDD and AIN were metallized by sputtering with W-Ti alloy/Au (2000 Å/ 25,000 Å). The W-Ti alloy on both the CVDD and the AIN consisted of 90% by weight W and 10% by weight Ti. The coatings were not heat treated. The diamond elements were then thermocompression bonded to the base element. Since both CVDD and AIN are such good thermal conductors, the temperatures normally used to bond Au to Au were not sufficient. The heat was drawn away too quickly. To achieve bonding, temperatures of 600°C were necessary. The bonds were very poor, all failures occurred at the CVDD/coating interface. The metallization did not adhere to the CVDD.

### Example 2

A series of AIN substrates (2 X 6 X 0.6 mm) was thermocompression bonded to CVDD substrates (1 X 0.6 X 0.26 mm). The CVDD and AIN were metallized by sputtering with W-Ti alloy/Au (2000 Å/ 25,000 Å). The W-Ti alloy on both the CVDD and the AIN consisted of 90% by weight W and 10% by weight Ti. The CVDD was heat treated after coating with both the W-Ti alloy and the Au layers at 900°C for 15 minutes. Bonding was performed at a variety of pressures ranging from 1400 to 2800 kg/cm² and temperatures ranging from 350°C to 700°C.

The best bonds occurred with pressures of about 2100 kg/cm². Very weak bonds were achieved at temperatures below 550°C. The best bonds were achieved at 625°C. The predominant failure mechanism was separation of the metallization from the CVDD. This was due in part to the rough surface of the CVDD (4000 Å R_{A}). It was also attributable to the transport of Ti into the Au during the heat treat cycle. Adhesion of 70 kg/cm² was obtained.

### Example 3

A series of AIN substrates (2 X 6 X 0.6 mm) was thermocompression bonded to CVDD substrates (1 X 0.6 X 0.26 mm). The CVDD was metallized by sputtering with W-Ti alloy/Ag/Au (2000 Å/ 7000 Å/ 25,000 Å). The AIN was metallized by sputtering with W-Ti alloy/Au (2000 Å/ 25,000 Å). The W-Ti alloy on both the CVDD and the AIN consisted of 90% by weight W and 10% by weight Ti. The CVDD was heat treated after coating with both the W-T alloy and the Ag layers at 900°C for 15 minutes. There was no heat treat after the Au coating. Bonding was performed at a variety of pressures ranging from 1400 to 2800 kg/cm² and temperatures ranging from 350°C to 700°C.

The best bonds occurred with pressures of about 2100 kg/cm². Very weak bonds were achieved at temperatures below 550°C. The best bonds were achieved at 625°C. There was no evidence of Ti migration. Adhesion of 600 kg/cm² was obtained. Failures occurred predominantly between the two Au metallizations.

## Claims

1. A method for metallization of a diamond substrate, said method comprising the following steps :
a. coating of a diamond substrate with a substrate transition metal layer, and,
b. overcoating of said substrate transition metal layer with at least one substrate precious metal layer selected from the group consisting of Ag and Au, and,
c. heat treating of the coated diamond substrate at a temperature and for a time sufficient to bond the substrate transition metal layer and the precious metal layer to said diamond.

2. A method to produce a heat spreader comprising the following steps :
a. preparing a diamond element by
i. depositing a substrate transition metal layer on a diamond substrate, and,
ii. depositing at least one substrate precious metal layer onto the said substrate transition metal layer selected from the group consisting of Ag and Au, and,
iii. heat treating the coated diamond substrate at a temperature and for a time sufficient to bond the metal layers to the diamond substrate, and,
b. preparing a base element by
i. depositing a base transition metal layer onto a base, and,
ii. depositing a base precious metal layer onto the base transition metal layer, and,
c. thermocompression bonding the diamond element to the base element.

3. A heat spreader, said heat spreader comprising the following elements :
a. a diamond element comprising
i. a diamond substrate, and,
ii. a substrate transition metal layer deposited onto and adhered to said diamond substrate, and,
iii. at least one substrate precious metal layer deposited onto and adhered to said substrate transition metal layer selected from the group consisting of Ag and Au, and,
b. a base element comprising
i. a base, and,
ii. a base transition metal layer deposited onto and adhered to said base, and,
iii. a base precious metal layer deposited onto and adhered to said base transition metal layer,
wherein, said diamond element is thermocompression bonded to said base element.

4. A method or spreader in accordance with Claim 1, 2 or 3 wherein said diamond substrate comprises chemically vapor deposited diamond.

5. A method or spreader in accordance with Claim 1, 2, 3 or 4 wherein said substrate transition metal layer is selected from the group consisting of Ti, Nb, W, Cr, Mo and alloys thereof.

6. A method or spreader in accordance with Claim 1, 2, 3 or 4 wherein said substrate transition metal layer comprises W-Ti alloy, with a thickness of 500 to 10,000 Å.

7. A method or spreader in accordance with Claim 6 wherein substrate transition metal layer comprises from 1 to 50 percent by weight Ti with the balance being W.

8. A method or spreader in accordance with Claim 6, wherein said substrate transition metal layer comprises from 10 to 30 percent by weight Ti with the balance being W.

9. A method or spreader in accordance with any preceding claim, wherein said substrate precious metal layer consists essentially of Au with a thickness of 10,000 to 40,000 Å.

10. A method or spreader in accordance with any one of Claims 1 to 8, wherein two substrate precious metal layers are deposited :
i. a first substrate precious metal layer comprising Ag with a thickness of 1000 to 20,000 Å, and,
ii. a second substrate precious metal layer comprising Au with a thickness of 10,000 to 40,000 Å, said second substrate precious metal layer deposited onto the first substrate precious metal layer.

11. A method in accordance with Claim 1 or 2 or any claim dependent thereon wherein said heat treating is performed at temperatures of 680° to 960°C for 5 to 60 minutes in an atmosphere comprising 4 to 100% by volume of hydrogen with the balance argon.

12. A method in accordance with Claim 11, wherein said heat treating is performed after deposition of the substrate precious metal layer.

13. A method in accordance with Claim 10, wherein said heat treating is performed after deposition of the first substrate precious metal layer and before deposition of the second precious metal layer.

14. A method or spreader in accordance with Claim 2 or 3, wherein said base is selected from the group consisting of Al₂O₃, AlN, SiC and CuW.

15. A method or spreader in accordance with Claim 2, 3 or 4, wherein said base transition metal layer comprises W-Ti alloy with a thickness of 500 to 10,000 Å.

16. A method or spreader in accordance with Claim 2, 3,, 14 or 15 wherein said base precious metal layer comprises Au with a thickness of 10,000 to 40,000 Å.

17. A method or spreader in accordance with Claim 2, 3, 14 or 15 wherein said base previous metal layer comprises Ag with a thickness of 1000 to 20,000 Å.

18. A method or spreader in accordance with Claim 15, wherein said base transition metal layer comprises from 10 to 30 percent by weight Ti with the balance being W, said base transition metal layer having a thickness of 500 to 10,000 Å.

19. A method in accordance with Claim 2, wherein said thermocompression bonding is performed at pressures of 1400 to 2800 kg/cm² and at temperatures of 550° to 700°C.
